# DEMANDE DE BREVET EUROPEEN

(11) **EP 1 115 274 A1**
(43) Date de publication de la demande: **11.07.2001**
(21) Numéro de dépôt: 00403371.8
(22) Date de dépôt: 01.12.2000
(51) Int. Cl.: H05K 7/20

(54) **Module électrique de puissance et procédé pour sa fabrication**

(30) Priorité: 21.12.1999 FR 9916160
(71) Demandeur: Sagem S.A., 75016 Paris Cedex 9 (FR)
(72) Inventeur: Ploix, Olivier Dominique, 60240 Monneville (FR)
(74) Mandataire: Gorrée, Jean-Michel

(57) **Abrégé**

Module électrique comprenant, au moins une barre de liaison conductrice (1) supportant au moins un composant électronique de puissance (3) dont des contacts sont en appui sur une carte à circuits imprimés (7) adjacente à la barre (1) et sur une position (9) d'une barre conductrice de puissance (10) sous-jacente à la carte (7), un matériau isolant thermodurci enrobant au moins les bords adjacents de la carte (7) et des barres conductrices (1, 10) pour maintenir rigidement les faces supérieures de la barre (1) , de la carte (7) et de la portion (9) de la barre (10) dans des positions relatives prédéterminées.

## Description

La présente invention concerne des perfectionnements apportés à la structure et à la fabrication de modules électriques de puissance qui incluent un ou plusieurs composants électroniques de puissance, tels que des transistors de puissance. De tels modules trouvent une application particulière, bien que non exclusive, dans le domaine automobile où l'on utilise des circuits électroniques qui alimentent des organes du moteur ou des éléments fonctionnels divers (par exemple un moteur électrique d'entraînement d'un groupe électropompe pour une assistance de direction d'un véhicule automobile).

Ces modules sont placés dans une ambiance à température élevée, ce qui complique l'évacuation de la chaleur dissipée par le ou les composants électroniques de puissance.

On a déjà proposé des réalisations de modules électriques dont l'agencement est élaboré autour d'un substrat métallique, notamment en aluminium ou alliage d'aluminium, les pièces composantes (carte à circuits imprimés, barres conductrices équipotentielles, ...) étant solidarisées notamment à l'aide de vis, boulons ou rivets pour les maintenir plaquées étroitement les unes contre les autres avec une bonne conduction thermique et/ou électrique.

Toutefois il apparaît souhaitable pour la pratique de réduire autant que faire se peut le poids et le coût de ces modules, ainsi que le nombre de ses pièces composantes.

Au surplus, il est nécessaire que la structure du module soit réalisée en compatibilité avec les composants électroniques dont il est équipé. A cet égard, les composants électroniques de puissance se présentent en général sous forme d'un boîtier comportant au moins une face plane propre à être mise en appui contre un support sur lequel est fixé ce boîtier (notamment par soudure) de façon à assurer la conduction électrique, d'une part, et l'évacuation de la chaleur, d'autre part. De ce boîtier s'étendent plusieurs contacts en forme de lames configurées de façon à présenter des surfaces d'appui respectives qui s'étendent à des niveaux prédéterminés par rapport à ladite face d'appui du boîtier (souvent ces surfaces des lames de contact sont coplanaires avec la face d'appui du boîtier). Il est donc nécessaire, lors de l'assemblage des pièces composantes de la structure du module, que les surfaces destinées à recevoir les faces d'appui des boîtiers des composants et la surface d'appui des contacts respectifs soient correctement positionnées les unes par rapport aux autres pour que les composants de puissance puissent y être ensuite correctement montés (notamment par soudure) et fixés.

La présente invention vise donc notamment à fournir un module électrique répondant mieux aux diverses exigences de la pratique que ceux actuellement connus, tout en conservant une résistance thermique réduite dans le circuit de dissipation de la chaleur permettant aux composants électroniques de puissance de supporter des pointes rapides d'échauffement.

A ces fins, l'invention propose un module électrique qui comprend :
- au moins une barre constituant liaison équipotentielle en matériau électriquement conducteur ;
- au moins un composant électronique de puissance en contact direct avec ladite barre conductrice ;
- une carte à circuits imprimés portant des composants électroniques à dissipation thermique réduite du module, cette carte étant disposée adjacente à la susdite barre conductrice avec sa face supérieure disposée dans une situation prédéterminée par rapport à celle de ladite barre conductrice ;
- au moins une barre conductrice de passage de courant de puissance sous-jacente à la carte à circuits imprimés et présentant au moins une portion ayant une face supérieure adjacente à la susdite barre conductrice et dans une situation prédéterminée par rapport à celle de ladite barre conductrice ;
- le susdit composant de puissance ayant des contacts raccordés respectivement à un circuit imprimé de la susdite carte à circuits imprimés et à la face supérieure de ladite portion de la barre conductrice de puissance ;
- et des couches supérieure et inférieure d'un matériau isolant thermodurci recouvrant les susdites barre conductrice, carte à circuits imprimés et barre conductrice de puissance dans leurs zones mutuellement adjacentes de manière à rigidifier l'ensemble ainsi constitué et à maintenir les positions relatives des surfaces précitées afin d'assurer la fiabilité de la continuité électrique des contacts du composant de puissance.

Avantageusement, la carte à circuits imprimés et la barre conductrice de puissance sont solidarisées l'une à l'autre par interposition d'une pellicule électriquement isolante adhésive polymérisée.

Dans un mode de réalisation compact, la carte à circuits imprimés porte des pistes conductrices sur ses deux faces pour assurer des liaisons avec la ou les barres conductrices et/ou pour monter des composants sur la face inférieure là où elle déborde de la ou des barres conductrices de puissance. Toujours dans le but d'aboutir à une structure plus compacte dans laquelle les pièces composantes peuvent s'emboîter les unes dans les autres au moins en partie, on prévoit que la carte à circuits imprimés comporte des découpes et/ou des lumières pour donner passage à des portions de la ou des barres conductrices de puissance en vue d'autoriser un raccordement de contact avec un composant électronique de puissance supporté par la barre conductrice.

Dans des structures complexes et importantes, il peut être envisagé que le module comporte plusieurs barres conductrices électriquement indépendantes les unes des autres et juxtaposées et/ou plusieurs barres conductrices de puissance électriquement indépendantes les unes des autres et juxtaposées.

Pour assurer le positionnement mutuel correct des diverses pièces composantes de la structure et obtenir au bout du compte un ensemble rigide, on prévoit que le matériau isolant thermodurci est disposé sous forme de bandes qui au moins chevauchent les zones adjacentes de la carte à circuits imprimés, de la ou des barres conductrices et de la ou des barres conductrices de puissance, en remplissant les intervalles existant entre cette carte et ces barres. Toutefois, de façon avantageuse, on peut faire en sorte que le matériau isolant durci recouvre toute la surface inférieure des barres conductrice et conductrice de puissance et recouvre la surface supérieure de la carte à circuits imprimés et de la barre conductrice à l'exclusion des emplacements de montage des composants électroniques, de manière que le matériau polymérisé s'étende sur des surfaces importantes et adhère mieux aux pièces composantes sous-jacentes, en conférant ainsi à l'ensemble une résistance mécanique accrue et une meilleure protection des surfaces métalliques contre les souillures et des risques de courts-circuits.

Dans un mode de réalisation pratique, les faces supérieures de la carte à circuits imprimés, de la barre conductrice et de ladite portion de la barre conductrice de puissance sont maintenues dans une situation de sensible coplanéité mutuelle.

Selon un autre de ses aspects, l'invention propose un procédé spécifique pour la fabrication du module électrique qui vient d'être décrit, lequel procédé se caractérise en ce que :
- on assemble de façon superposée une carte à circuits imprimés et au moins une barre conductrice de puissance avec interposition d'une feuille électriquement isolante adhésive double face,
- on juxtapose au moins une barre conductrice et ledit assemblage constitué de la carte à circuits imprimés et d'au moins une barre conductrice de puissance,
- on met en place au moins des bandes de matériau isolant adhésif qui au moins chevauchent des zones adjacentes de la carte à circuits imprimés, de la barre conductrice et de la barre conductrice de puissance en épargnant les emplacements destinés à recevoir des composants électroniques, et on bloque l'ensemble de manière que des surfaces déterminées de la carte à circuits imprimés, de la barre conductrice et de la barre conductrice de puissance soient maintenues dans des positions relatives prédéterminées,
- on chauffe l'ensemble pour polymériser et durcir les adhésifs et constituer un module monobloc,
- et on monte, notamment par soudage, au moins un composant électronique de puissance sur la barre conductrice, de façon telle que ses contacts soient en appui sur la carte à circuits imprimés et sur une face de la barre conductrice de puissance, ainsi que des composants électroniques à dissipation thermique réduite sur la carte à circuits imprimés.

Grâce aux dispositions de l'invention, on dispose d'un module électrique perfectionné qui, tout en conservant les caractéristiques de conduction thermique et électrique requises pour son fonctionnement correct, présente en outre une grande rigidité et un positionnement mutuel correct des pièces composantes de sa structure propre à satisfaire un montage approprié des composants électroniques de puissance.

Au surplus, ces avantages sont acquis conjointement avec la suppression du substrat métallique et des vis, boulons ou rivets de fixation requis dans les modules antérieurs, et s'accompagnent donc d'une réduction sensible du poids du module électrique, du nombre de ses pièces composantes et de son coût.

L'invention sera mieux comprise à la lecture de la description détaillée qui suit de certains modes de réalisation donnés uniquement à titre d'exemples non limitatifs. Dans cette description, on se réfère aux dessins annexés sur lesquels :
- la figure 1 est une vue en plan, de dessus, d'une partie d'un module électrique agencé conformément à l'invention ;
- les figures 2 à 4 sont des vues en coupe transversale, respectivement selon les lignes II-II, III-III et IV-IV, de la figure 1 ;
- la figure 5 est une vue en perspective d'un module électrique agencé selon l'invention dans lequel la carte à circuits imprimés a été enlevée ;
- la figure 6 est une vue en perspective du module électrique de la figure 5 avec la carte à circuits imprimés en place ; et
- la figure 7 est une vue en perspective d'une variante de réalisation du module électrique (carte à circuits imprimés non montrée) équipé d'une multiplicité de barres conductrices.

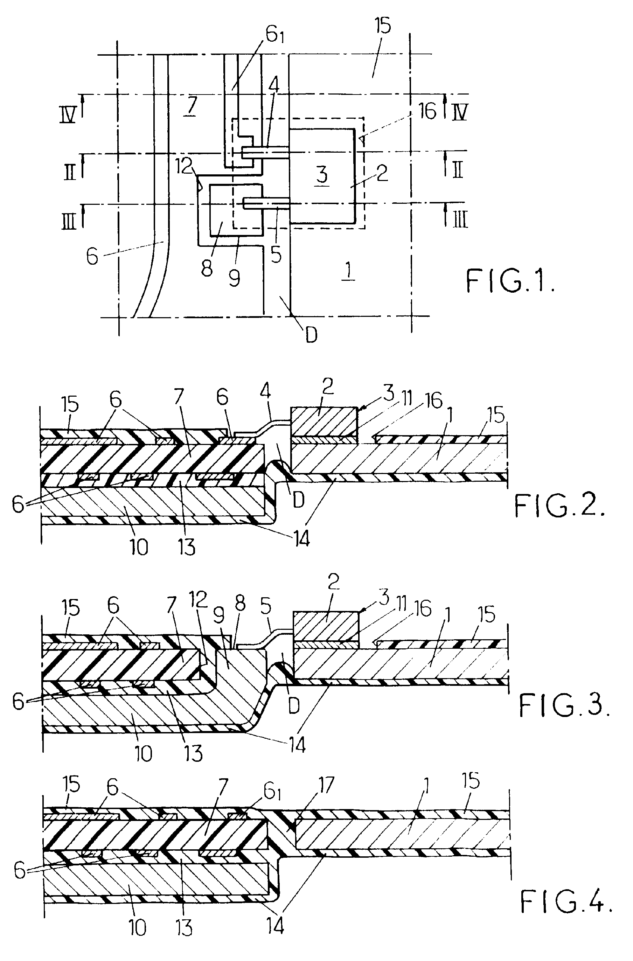

On se réfèrera tout d'abord aux figures 1 à 4 qui illustrent une partie d'un module électrique agencé conformément à l'invention. Le module comprend au moins une barre conductrice équipotentielle 1 sur un bord de la face supérieure de laquelle est fixé, notamment par soudure 11, le boîtier 2 d'un composant électronique de puissance 3 (par exemple un transistor, un thyristor, ...) de sorte que ce composant (dont le boîtier est métallique et constitue l'une des électrodes) est en contact intime de conduction thermique et électrique avec la barre conductrice 1.

Le composant électronique de puissance 3 comporte deux contacts 4 et 5 en forme de lames ou de pattes, saillant latéralement au-delà du bord de la barre conductrice 1.

Comme visible aux figures 1 et 2, l'un des contacts, 4, prend appui par son extrémité libre et est soudé sur une piste 6₁ d'une carte à circuits imprimés 7. La carte à circuits imprimés 7 porte une multiplicité de pistes 6 en cuivre à la fois sur sa face supérieure et sur sa face inférieure et elle est équipée, sur l'une et/ou l'autre desdites faces, de composants électroniques à dissipation thermique réduite (non montrés).

Comme visible aux figures 1 et 3, l'autre contact 5 du composant 3 prend appui par son extrémité libre et est soudé sur la face supérieure 8 d'une portion 9 d'une barre conductrice de puissance 10 qui est, en partie au moins, sous-jacente à la carte à circuits imprimés 7. La portion 9 précitée de la barre conductrice de puissance 10 peut être constituée par une excroissance tournée vers le haut de ladite barre (par exemple une patte découpée dans la barre et courbée vers le haut). Pour que cette excroissance 9 soit disposée correctement en regard de la barre conductrice 1 et du composant de puissance 3, on prévoit dans la carte à circuits imprimés 7 une découpe 12 dans son bord (ou une lumière si nécessaire) dans laquelle apparaît ladite excroissance 9.

Dans l'exemple illustré, le composant de puissance 3 est constitué de telle manière que la face d'appui des extrémités de ses contacts 4 et 5 soient sensiblement coplanaires avec la face d'appui de son boîtier 2 par laquelle il repose sur la barre conductrice 1. Ainsi, il est nécessaire que, d'une part, la face supérieure de la carte à circuits imprimés 7 avec sa piste 6₁ précitée et, d'autre part, la face supérieure 8 de la portion 9 de la barre conductrice de puissance 10 soient mutuellement sensiblement coplanaires et en outre soient sensiblement coplanaires avec la face supérieure de la barre conductrice 1.

Bien entendu, d'autres positions relatives que la position coplanaire peuvent être envisagées dans les mêmes conditions, en fonction de la conformation du composant électronique de puissance 3.

Pour maintenir la carte à circuits imprimés 7 et les deux barres conductrices 1 et 10 fermement réunies dans la position mutuelle requise, on prévoit :
- de solidariser la carte à circuits imprimés 7 et la barre conductrice de puissance 10 par une pellicule ou feuille électriquement isolante adhésive double face qui, par traitement thermique, polymérise sous forme d'une couche isolante rigide 13 solidarisant mécaniquement la carte 7 et la barre 10 ;
- on étend des bandes isolantes adhésives à cheval sur l'intervalle D séparant les bords affrontés de la carte à circuits imprimés 7, de la barre conductrice de puissance 10 avec ses portions en excroissance 9 et de la barre conductrice 1 ; les bandes sont disposées, sur le dessus, en épargnant les emplacements des composants électroniques de puissance 3 et de leurs contacts 4 et 5, et éventuellement les emplacements des composants électroniques à faible dissipation thermique sur la carte à circuits imprimés ; les bandes en regard, sur le dessous, s'étendent continûment ; ces bandes, par traitement thermique, polymérisent en coulant dans les intervalles libres qu'elles remplissent et, en durcissant, solidarisent mécaniquement la carte 7 et les barres 1 et 10 en les bloquant dans leurs positions mutuelles requises.

De façon préférée comme illustré aux figures 1 à 4, ce ne sont pas de simples bandes que l'on étend à cheval sur l'intervalle D, mais des pellicules ou feuilles qui recouvrent toute la surface inférieure et toute la surface supérieure à l'exception des emplacements des composants.

Après polymérisation, il s'est formé une couche rigide isolante inférieure 14, une couche rigide isolante supérieure 15 présentant des réserves 16 pour les composants électroniques, et un remplissage 17 de l'intervalle 12 (sauf éventuellement sous les pattes 4 et 5 du composant 3) que l'on observe à la figure 4 sur la coupe faite selon la ligne IV-IV de la figure 1 en dehors de la réserve 16.

Les dispositions conformes à l'invention permettent de constituer des ensembles comportant un grand nombre de composants électroniques de puissance, voire une multiplicité de barres conductrices et/ou de barres conductrices de puissance, sous forme de modules compacts et parfaitement rigides, constituant finalement des éléments monoblocs préfabriqués et faciles et implanter par exemple dans un véhicule automobile.

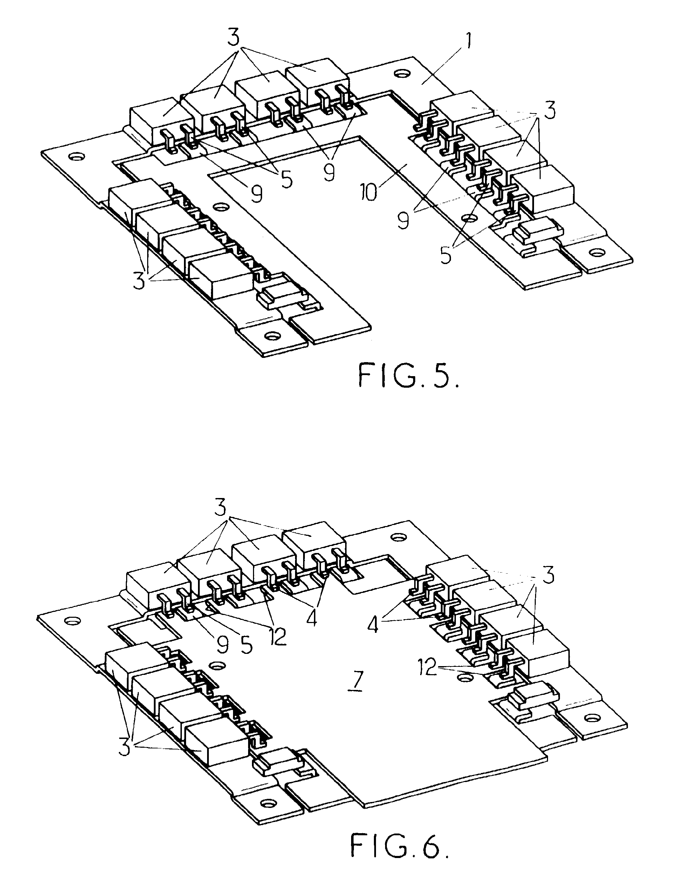

Pour fixer les idées, on a illustré aux figures 5 et 6 un exemple possible d'un ensemble constitué conformément à l'invention, mais non achevé (absence des couches polymérisées et des composants à faible dissipation thermique de la carte à circuits imprimés, notamment) afin de rendre les dessins mieux lisibles.

Sur la figure 5, on a illustré une barre conductrice 1 qui s'étend en forme de U et qui porte une multiplicité de composants électroniques de puissance 3 dont les contacts sont dirigés vers l'intérieur du U. A l'intérieur du U, et légèrement en contrebas de la barre conductrice 1, s'étend la barre conductrice de puissance 10 (visible car la carte à circuits imprimés n'est pas représentée) qui s'étend, elle aussi, en U et qui présente sur son bord externe des excroissances 9 (formées de pattes découpées et pliées) s'élevant jusque sous les contacts 5 des composants 3.

A la figure 6, on a complété la représentation de la figure 5 avec la carte à circuits imprimés 7 (les pistes ne sont pas représentées) dont le bord présente des découpes 12 laissant passage aux excroissances 9 précitées. Les contacts 4 des composants de puissance 3 sont en appui sur la carte 7.

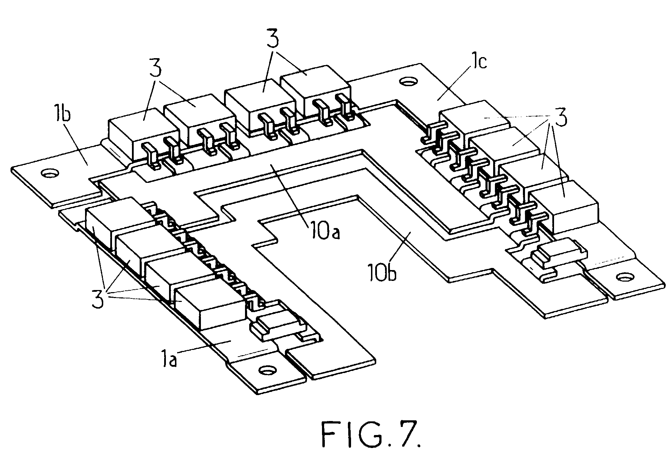

A la figure 7, on a illustré, dans les mêmes conditions qu'à la figure 5, une variante de réalisation qui met en oeuvre une multiplicité de barres conductrices 1 et de barres conductrices de puissance 10. La barre conductrice 1 unique de la figure 5 est remplacée par plusieurs (trois dans l'exemple illustré) tronçons de barres conductrices 1a, 1b, 1c, qui supportent les composants électroniques de puissance 3, lesquels peuvent alors avoir leurs boîtiers portés à des potentiels différents. De la même manière, la barre conductrice de puissance 10 unique de la figure 5 est remplacée par plusieurs (deux dans l'exemple représenté) tronçons de barres conductrices de puissance 10a et 10b dont les conformations sont appropriées pour réunir les contacts 5 des composants 3 requis.

Bien entendu des agencements plus complexes sont envisageables, et il est possible que les barres conductrices 1 et/ou les barres conductrices de puissance 10 soient imbriquées les unes dans les autres et éventuellement se chevauchent : des bandes isolantes adhésives polymérisables seront alors mises en place aux endroits requis pour éviter les courts-circuits et rigidifier l'ensemble.

On comprend, d'après les explications qui précèdent, que la fabrication d'un module électrique conforme à l'invention peut s'effectuer dans des conditions conduisant à un coût sensiblement réduit, tout en aboutissant à un ensemble monobloc rigide et mécaniquement résistant. Pour fabriquer un tel module, on procède selon les étapes suivantes :
- on assemble de façon superposée une carte à circuits imprimés et au moins une barre conductrice de puissance avec interposition d'une feuille électriquement isolante adhésive double face,
- on juxtapose ledit assemblage et au moins une barre conductrice,
- on met en place au moins des bandes de matériau électriquement isolant adhésif qui au moins chevauchent des zones adjacentes de la carte à circuits imprimés, de la barre conductrice de puissance et de la barre conductrice en épargnant les emplacements destinés à recevoir des composants électroniques, et on bloque l'ensemble de manière que des surfaces déterminées de la carte à circuits imprimés, de la barre conductrice de puissance et de la barre conductrice soient maintenues dans des positions relatives prédéterminées,
- on chauffe l'ensemble pour ramollir les isolants adhésifs et faire en sorte qu'ils occupent tous les intervalles libres, puis on les laisse polymériser en durcissant pour constituer un ensemble monobloc rigide,
- et enfin, on monte, notamment par soudage, au moins un composant électronique de puissance sur la barre conductrice de façon telle que ses contacts soient en appui sur la carte à circuits imprimés et sur une face de la barre conductrice de puissance, ainsi que des composants électroniques à dissipation thermique réduite sur la carte à circuits imprimés.

Le module ainsi obtenu présente une bonne rigidité mécanique et notamment les barres conductrices, constituées en métal électriquement bon conducteur (par exemple en cuivre ou à base de cuivre) ayant un coefficient de dilatation thermique élevé, sont maintenues mécaniquement dans des conditions telles que, malgré l'atmosphère ambiante à température élevée due à la proximité du moteur du véhicule, on évite des déformations de ces barres qui entraîneraient des efforts importants sur les contacts des composants de puissance avec un risque de rupture de ces contacts.

## Revendications

1. Module électrique comprenant :
- au moins une barre (1) constituant liaison équipotentielle en matériau électriquement conducteur ;
- au moins un composant électronique de puissance (3) en contact direct avec ladite barre conductrice (1) ;
- une carte à circuits imprimés (7) portant des composants électroniques à dissipation thermique réduite du module, cette carte étant disposée adjacente à la susdite barre conductrice (1) avec sa face supérieure disposée dans une situation prédéterminée par rapport à celle de ladite barre conductrice (1) ;
- au moins une barre conductrice de passage de courant de puissance (10) sous-jacente à la carte à circuits imprimés (7) et présentant au moins une portion (9) ayant une face supérieure (8) adjacente à la susdite barre conductrice et dans une situation prédéterminée par rapport à celle de ladite barre conductrice (1) ;
- le susdit composant de puissance (3) ayant des contacts (4, 5) raccordés respectivement à un circuit imprimé de la susdite carte à circuits imprimés (7) et à la face supérieure (8) de ladite portion (9) de la barre conductrice de puissance (10) ;
- et des couches supérieure (15) et inférieure (14) d'un matériau isolant thermodurci recouvrant les susdites barre conductrice (1), carte à circuits imprimés (7) et barre conductrice de puissance (10) dans leurs zones mutuellement adjacentes de manière à rigidifier l'ensemble ainsi constitué et à maintenir les positions relatives des surfaces précitées afin d'assurer la fiabilité de la continuité électrique des contacts du composant de puissance.

2. Module électrique selon la revendication 1, caractérisé en ce que la carte à circuits imprimés (7) et la barre conductrice de puissance (10) sont solidarisées l'une à l'autre par interposition d'une pellicule électriquement isolante adhésive polymérisée (13).

3. Module électrique selon la revendication 1 ou 2, caractérisé en ce que la carte à circuits imprimés (7) porte des pistes conductrices (6) sur ses deux faces pour assurer des liaisons avec la ou les barres conductrices (1, 10) et/ou pour monter des composants sur la face inférieure là où elle déborde de la ou des barres conductrices de puissance (10).

4. Module électrique selon l'une quelconque des revendications précédentes, caractérisé en ce que la carte à circuits imprimés (7) comporte des découpes (12) et/ou des lumières pour donner passage à des portions (9) de la ou des barres conductrices de puissance (10) afin d'autoriser un raccordement de contact avec un composant électronique de puissance (3) porté par la barre conductrice (1).

5. Module électrique selon l'une quelconque des revendications précédentes, caractérisé en ce qu'il comporte plusieurs barres conductrices (1) électriquement indépendantes les unes aux autres et juxtaposées.

6. Module électrique selon l'une quelconque des revendications précédentes, caractérisé en ce qu'il comporte plusieurs barres conductrices de puissance (10) électriquement indépendantes les unes des autres et juxtaposées.

7. Module électrique selon l'une quelconque des revendications précédentes, caractérisé en ce que le matériau isolant thermodurci est disposé sous forme de bandes qui au moins chevauchent les zones adjacentes de la carte à circuits imprimés (7), de la ou des barres conductrices (1) et de la ou des barres conductrices de puissance (10), en remplissant les intervalles (17) existant entre cette carte et ces barres.

8. Module électrique selon la revendication 7, caractérisé en ce que le matériau isolant durci recouvre toute la surface inférieure des barres conductrice (1) et conductrice de puissance (10) et recouvre la surface supérieure de la carte à circuits imprimés (7) et de la barre conductrice (1) à l'exclusion (16) des emplacements de montage des composants électroniques.

9. Module électrique selon l'une quelconque des revendications précédentes, caractérisé en ce que les faces supérieures de la carte à circuits imprimés (7), de la barre conductrice (1) et de ladite portion (9) de la barre conductrice de puissance (10) sont maintenues dans une situation de sensible coplanéité mutuelle.

10. Procédé de fabrication d'un module électrique selon l'une quelconque des revendications précédentes, caractérisé en ce que :
- on assemble de façon superposée une carte à circuits imprimés (7) et au moins une barre conductrice de puissance (10) avec interposition d'une feuille électriquement isolante adhésive double face (13),
- on juxtapose au moins une barre conductrice (1) et ledit assemblage constitué de la carte à circuits imprimés (7) et d'au moins une barre conductrice de puissance (10),
- on met en place au moins des bandes de matériau isolant adhésif (14, 15) qui au moins chevauchent des zones adjacentes de la carte à circuits imprimés (7), de la barre conductrice (1) et de la barre conductrice de puissance (10) en épargnant les emplacements destinés à recevoir des composants électroniques, et on bloque l'ensemble de manière que des surfaces déterminées de la carte à circuits imprimés, de la barre conductrice et de la barre conductrice de puissance soient maintenues dans des positions relatives prédéterminées,
- on chauffe l'ensemble pour polymériser et durcir les adhésifs et constituer un module monobloc,
- et en ce qu'on monte, notamment par soudage, au moins un composant électronique de puissance (3) sur la barre conductrice (1), de façon telle que ses contacts (4, 5) soient en appui sur la carte à circuits imprimés (7) et sur une face (8) de la barre conductrice de puissance (10), ainsi que des composants électroniques à dissipation thermique réduite sur la carte à circuits imprimés (7).
